# EUROPEAN PATENT APPLICATION

(11) **EP 2 573 828 A2**
(43) Date of publication of application: **27.03.2013**
(21) Application number: 12180282.1
(22) Date of filing: 13.08.2012
(51) Int. Cl.: H01L 33/50, H01L 33/64

(54) **Manufacturing method for light-emitting device and the light-emitting device**

(30) Priority: 26.09.2011 JP 2011208949
(71) Applicant: Toshiba Lighting & Technology Corporation, Yokosuka-shi Kanagawa 237-8510 (JP)
(72) Inventor: Watanabe, Miho, Kanagawa, 237-8510 (JP); Bezsuda, Nobuhiko, Kanagawa, 237-8510 (JP); Tanaka, Hirotaka, Kanagawa, 237-8510 (JP)
(74) Representative: Willquist, Sofia Ellinor

(57) **Abstract**

According to one embodiment, a manufacturing method for a light-emitting device (10) includes: mounting a light-emitting element (3) on a substrate (1); and dispersing, in liquid transparent resin, phosphor particles in micron order excited by light radiated from the light-emitting element to emit light and electrostatically applying or electrostatically spraying dispersed liquid of the phosphor particles to thereby form a layer (4) including the phosphor particles on the upper surface of the light-emitting element (3).

## Description

### CROSS-REFERENCE TO RELATED APPLICATION

This application is based upon and claims the benefit of priority from Japanese Patent Application No. P2011-208949, filed on September 26, 2011; the entire contents of which are incorporated herein by reference.

### FIELD

Embodiments described herein relate generally to a manufacturing method for a light-emitting device.

### BACKGROUND

While the application of a light-emitting device (an LED lamp) including light-emitting diode (LED) chips to general lighting is rapidly expanded, a light-emitting device in which LED chips are mounted on a wired substrate and the surfaces of the LED chips are individually covered with phosphor layers attracts attention because only a small amount of expensive phosphors have to be used.

On the other hand, the power of LED lamps increases year after year. Heat generation due to a stokes loss of phosphors themselves increases to a problematic level. In order to efficiently allow such heat due to an energy loss of the phosphors themselves to escape, it is desirable to form the phosphor layers as coating along the surface shape of the LED chips, i.e., conformal coating and improve heat conduction from the phosphors to the LED chips. Occurrence of color unevenness and the like can also be suppressed by forming the phosphor layers as the conformal coating.

However, it may be extremely difficult to apply the conformal coating to the surfaces of small elements like the LED chips. In particular, in the case of chips of a very small size such as 0.2mmx0.2mm, it may be more difficult to apply the conformal coating. The above mentioned technology is disclosed in Japanese Patent Application Laid-Open No. PH10-319877, and contents of which are hereby incorporated by reference.

### BRIEF DESCRIPTION OF THE DRAWINGS

FIG. 1 is a sectional view of an example of a light-emitting device manufactured according to an embodiment;
FIGS. 2A and 2B are enlarged diagrams of a main part of the light-emitting device shown in FIG. 1, wherein FIG. 2A is a sectional view and FIG. 2B is a top view;
FIG. 3 is a schematic diagram of an example of an electrostatic coating device used in the embodiment;
FIG. 4 is a sectional view of a modification of the light-emitting device shown in FIG. 1;
FIG. 5 is a sectional view of another modification of the light-emitting device shown in FIG. 1;
FIG. 6 is a sectional view of an example of a light-emitting device manufactured according to another embodiment;
FIG. 7 is an enlarged sectional view of a main part of the light-emitting device shown in FIG. 6; and
FIGS. 8A and 8B are sectional views of an example of a light-emitting device manufactured according to a comparative example.

### DETAILED DESCRIPTION

According to one aspect of an embodiment, a manufacturing method for a light-emitting device includes: mounting a light-emitting element on a substrate; and dispersing, in liquid transparent resin, phosphor particles in micron order excited by light radiated from the light-emitting element to emit light and electrostatically applying or electrostatically spraying dispersed liquid of the phosphor particles to thereby form a layer including the phosphor particles on the upper surface of the light-emitting element.

According to the embodiment, there is provided a method that can form a phosphor layer with high conformality even in an LED chip of a very small size and manufacture a light-emitting device excellent in thermal radiation properties and with less color unevenness and the like.

According to the embodiment, it is possible to form a phosphor layer with high conformality even in an LED chip of a very small size and manufacture a light-emitting device excellent in thermal radiation properties and with less color unevenness and the like.

Embodiments are explained below with reference to the accompanying drawings. In the following description of the drawings, unless specifically noted otherwise, the same components or components having the same functions are denoted by the same reference numerals and signs and redundant explanation of the components is omitted.

### First Embodiment

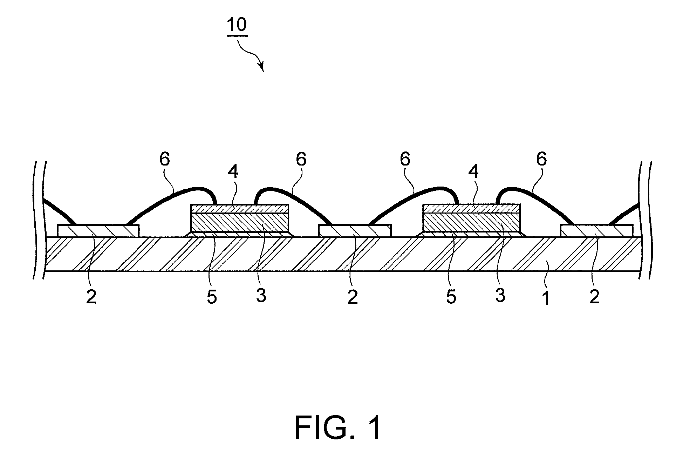

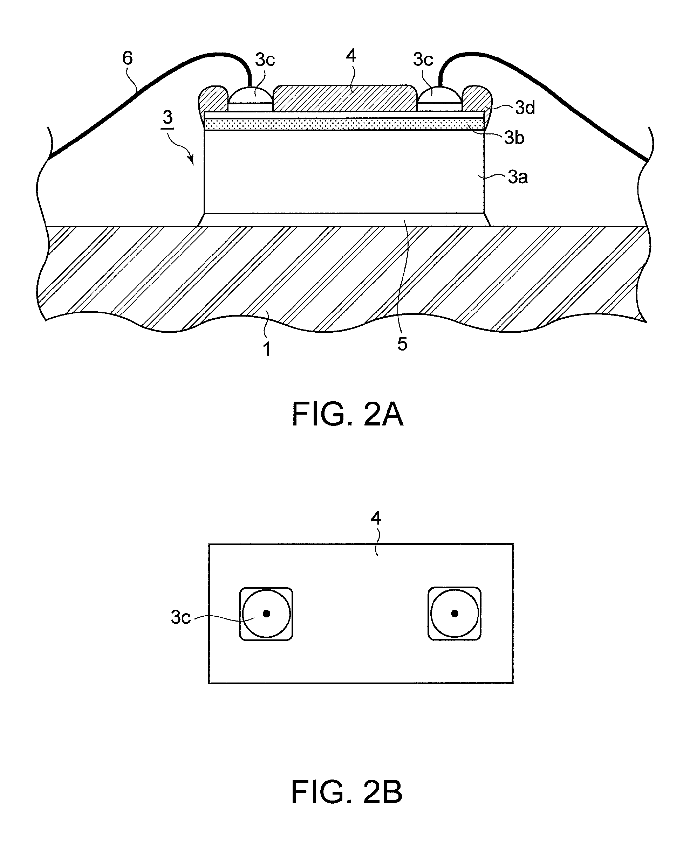

FIG. 1 is a sectional view of an example of a light-emitting device manufactured according to a first embodiment. FIGS. 2A and 2B are enlarged diagrams of a main part of the light-emitting device, wherein FIG. 2A is a sectional view and FIG. 2B is a plan view.

A light-emitting device 10 shown in FIG. 1 and FIGS. 2A and 2B includes a substrate 1, wiring layers 2 formed on the substrate 1, LED chips 3 functioning as light-emitting elements, and phosphor layers 4.

The substrate 1 is made of a flat plate of aluminum (Al), nickel (Ni), glass epoxy, ceramic, or the like having thermal radiation properties and rigidity.

The substrate 1 desirably has thickness of 0.5 mm to 1.5 mm. In the substrate 1, heat conductivity at 25°C is equal to or higher than 30 W/m.K. If the thickness of the substrate 1 is smaller than 0.5 mm, strength of the substrate 1 is insufficient. It is likely that a crack occurs during attachment to an appliance or the like and during operation. If the thickness of the substrate 1 exceeds 1.5 mm, even if the heat conductivity is equal to or higher than 30 W/m.K, it is likely that the heat radiation properties of the entire substrate 1 are insufficient. The heat conductivity of the substrate 1 can be calculated from a temperature difference between a junction temperature and a substrate most cold point and the structure of the substrate 1 using, for example, a thermal resistance measuring device.

The wiring layers 2 are layers mainly formed of conductive metal such as silver (Ag), gold (Au), or copper (Cu). The wiring layers 2 can be formed by printing (screen printing, inkjet printing, etc.) paste (ink) containing conductive powder (particulates) of Ag or the like on the surface of the substrate 1 in a desired pattern and then drying and baking an application layer.

As the LED chips 3, which are the light-emitting elements, for example, LED chips that emit blue light having main wavelength of 420 nm to 480 nm (e.g., 460 nm) or LED chips that emit an ultraviolet ray are used. However, the LED chips 3 are not limited to these LED chips. The LED chips 3 only have to be LED chips that radiate light and excite phosphors with the radiated light to generate visible light. Various light-emitting elements can be used according to the use of the light-emitting device 10, a target light emission color, and the like.

The LED chip 3 has a structure in which a semiconductor light-emitting layer 3b is formed on an insulative element substrate 3a and a pair of electrodes 3c, 3c are formed on the semiconductor light-emitting layer 3b. The LED chip 3 is bonded (die-bonded) on the substrate 1 by an adhesive 5. The pair of electrodes 3c, 3c are respectively connected to the wiring layers 2 via bonding wires 6 such as metal wires. In other words, the LED chip 3 is mounted on the substrate 1 with its face up, i.e., with the surface on the formation side of the semiconductor light-emitting layer 3b faced up.

The phosphor layer 4 is formed by electrostatically applying dispersed liquid, in which one or two or more kinds of phosphor particles are dispersed in liquid transparent resin, to the upper surface of the LED chip 3 mounted on the substrate 1 with its face up in this way and corners 3d continuous from the upper surface and thereafter hardening the applied resin. By using the electrostatic application, as shown in FIG. 2A, the phosphor layer 4 is formed at uniform or substantially uniform thickness on the upper surface of the LED chip 3 excluding forming portions of the element electrodes 3c, 3c and on the corners 3d continuous from the upper surface. In this specification, when "uniform or substantially uniform thickness" is referred to concerning the phosphor layer, the thickness means thickness at which "color unevenness" explained below does not occur when the light-emitting device is caused to emit light.

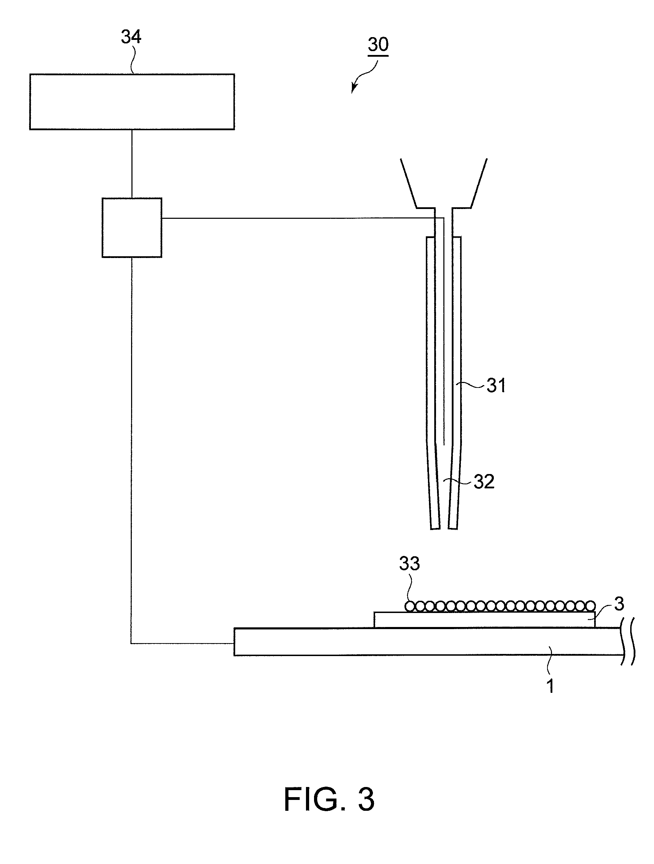

FIG. 3 is a schematic diagram of an example of an electrostatic coating device 30 used for the formation of the phosphor layer 4. The electrostatic coating device 30 applies a pulse voltage between the substrate 1 mounted with the LED chip 3 and a spraying nozzle 31, draws out, with an electrostatic force of the pulse voltage, a liquid material (dispersed liquid in which phosphor particles are dispersed in liquid transparent resin) 32 at the distal end of the spraying nozzle 31 as very small liquid droplets 33, for example, liquid droplets of 50 µm to 100µm, and attracts the very small liquid droplets 33 to the substrate 1 with an electric field to enable the liquid material 32 to be applied to the LED chip 3 on the substrate 1. In such an electrostatic coating device 30, the liquid material 32 can be applied to a required region from the upper surface to the side surfaces of the LED chip 3 by relatively moving the position of the distal end of the spraying nozzle 31 with respect to the substrate 1 in the horizontal direction or relatively changing the direction (the angle) of the distal end of the spraying nozzle 31. A uniform or substantially uniform film (the phosphor layer 4) can be formed by hardening the applied liquid material. In this embodiment, the liquid material 32 is applied to the upper surface of the LED chip 3 excluding the forming portions of the element electrodes 3c, 3c and on the corners 3d continuous from the upper surface. The phosphor layer 4 having the uniform or substantially uniform thickness is formed in those regions. In FIG. 3, reference numeral 34 denotes a pulse voltage generating device. The LED chip 3 is not broken or the functions of the LED chip 3 are not lost by the pulse voltage applied between the substrate 1 and the spraying nozzle 31 by the pulse voltage generating device 34.

Examples of the liquid transparent resin used for the electrostatic application include silicone resin and epoxy resin. Above all, the use of the silicone resin is desirable from the viewpoint of light resistance, heat resistance, and the like.

As the phosphors, various phosphors excited by the light from the LED chip 3 are used.

For example, as a phosphor excited by blue light, for example, a YAG phosphor such as an RE₃(Al,Ga)₅O₁₂:Ce phosphor (RE indicates at least one kind selected from Y, Gd, and La) emitting a yellow light or an orange light, a silicate phosphor such as an AE₂SiO₄:Eu phosphor (AE is an alkali earth element such as Sr, Ba, or Ca. The same applies below), a yellow phosphor such as a sialon phosphor (e.g., CaₓSi_{y}Al_{z}ON: Eu²⁺), a YAG phosphor such as RE₃(Al,Ga)₅O₁₂:Ce phosphor (RE indicates at least one kind selected from Y, Gd, and La. The same applies below) used together with the yellow phosphor in order to improve a color rendering property, a silicate phosphor such as an AE₂SiO₄:Eu phosphor (AE is an alkali earth element such as Sr, Ba, or Ca. The same applies below), a sialon phosphor (e.g., CaₓSi_{y}Al_{z}ON:Eu²⁺), or a red phosphor such as a nitride phosphor (CASN) (e.g., CaAlSiN₃:Eu) is used. These phosphors emit yellow light or orange light.

As a phosphor excited by ultraviolet light, for example, an oxysulphide phosphor such as La₂O₃S:Eu³⁺ phosphor, a germinate phosphor of manganese activated magnesium fluorogermanate (2.5MgO.MgF₂:Mn ⁴⁺) or the like, a nitride phosphor (e.g., AE₂Si₅N₈:Eu or CaAlSiN₃:Eu), an oxynitride phosphor (e.g., Y₂Si₃O₃N₄:Ce), or a sialon phosphor (e.g., AEₓ(Si,Al)₁₂(N,O)₁₆:Eu) is used. These phosphors are selected and used as appropriate according to a target light emission color or the like of the light-emitting device 10.

As the phosphor particles, phosphor particles having a particle diameter in micro order, i.e., a particle diameter of about several micrometers to several ten micrometers are used. The phosphor particles desirably have an average particle diameter of 3 µm to 20µm and more desirably have an average diameter of 3 µm to 10µm. If the average particle diameter of the phosphor particles is smaller than 3 µm, external quantum efficiency of the phosphors themselves falls and light emission efficiency falls. If the average particle diameter exceeds 20 µm, the particle diameter of liquid droplets increases. Depending on the size of the LED chip 3, it is likely that it may be difficult to selectively apply the liquid material 32 to the required region at the uniform thickness explained above. It may be difficult to disperse particles having an average particle diameter exceeding 20 µm for a long time without precipitating the particles in resin. The particle diameter and the average particle diameter of the phosphors can be calculated by, for example, a laser diffraction particle size analyzer. The average particle diameter is a particle diameter at which loading weight is 50% in a particle size distribution measured by the analyzer.

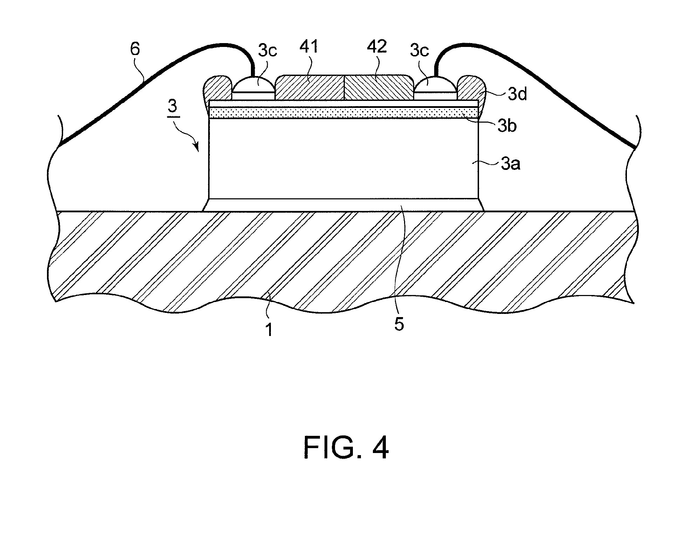

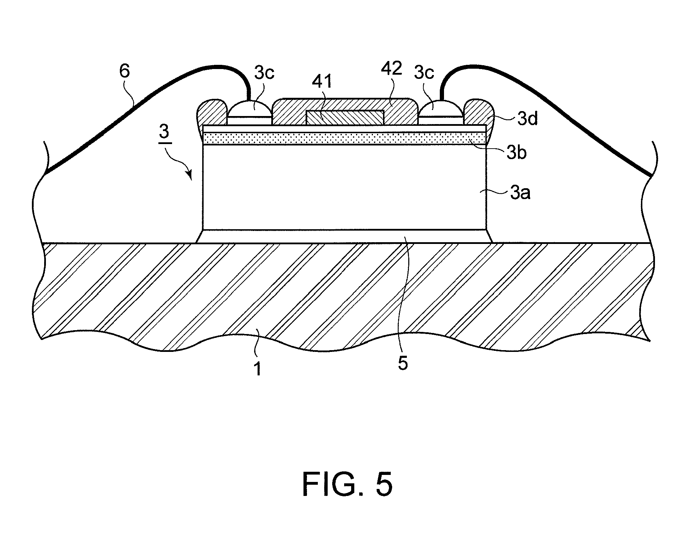

In FIG. 1 and FIGS. 2A and 2B, the phosphor layer 4 is formed as a homogenous layer as a whole using one kind of dispersed liquid in which one or two or more kinds phosphor particles are uniformly dispersed in the liquid transparent resin. However, as shown in FIGS. 4 and 5, different phosphors or the like may be contained depending on regions using two or more kinds of dispersed liquid having different compositions. In an example shown in FIG. 4, the upper surface of the LED chip 3 is divided into two regions. Phosphor layers 41 and 42 containing different phosphors are respectively formed in the regions. In an example shown in FIG. 5, the phosphor layers 41 and 42 containing different phosphors are provided to be vertically laminated.

For the purpose of improving heat conductivity of the phosphor layer 4, an inorganic filler having satisfactory heat conductivity and optical transparency can be contained in the dispersed liquid together with the phosphor particles. The inorganic filler only has to be an inorganic filler having satisfactory heat conductivity and optical transparency. For example, powder of silica, tantalum oxide (TaO), or zinc oxide (ZnO) is used. These inorganic fillers can be used independently or two or more kinds of the inorganic fillers can be mixed and used. An inorganic filler having a particle diameter smaller than the particle diameter of the phosphors in use is desirably used. By using such an inorganic filler having a particle diameter smaller than the particle diameter of the phosphors, it is possible to fill gaps among the particles of the phosphors and improve transmissibility of heat generated by the phosphor particles to LED chips. The particle diameter of the inorganic filler can be calculated by, for example, a laser diffraction particle size analyzer. An inorganic filler having a particle diameter in submicron order, i.e., a particle diameter of about several hundred nanometers is desirably used.

In such a light-emitting device 10, since the phosphor layer 4 is formed by the electrostatic application, the phosphor layer 4 is formed in substantially uniform thickness on the upper surface of the LED chip 3 excluding the forming portions of the element electrodes 3c, 3c and on the corners 3d continuous from the upper surface. Therefore, the heat conduction from the phosphor to the LED chip 3 can be improved and the heat radiation properties can be improved. Therefore, it is possible to sufficiently cope with the increase in power of a light-emitting device in recent years and realize light emission at a large light amount and high efficiency. Since phosphors do not excessively adhere, it is possible to reduce a phosphor amount.

Further, since the thickness is uniform, it is possible to suppress occurrence of color unevenness. If the thickness is non-uniform and the phosphor layer 4 is not provided on the corners 3d of the LED chip 3 or the thickness of the phosphor layer 4 is insufficient, it is likely that light radiated from the LED chip 3 leaks to the outside from the corners 3d and, for example, in the case of the LED chip that emits blue light, a so-called blue ring phenomenon occurs. In the light-emitting device 10 according to this embodiment, since the required phosphor layer having thickness substantially equal to the thickness of the upper layer is also provided on the corners 3d, such a blue ring phenomenon does not occur.

This embodiment has an advantage that, in particular, even if the LED chip 3 is, for example, an LED chip of a very small size of 0.2mmx0.2mm having an area of 0.04 mm², it is possible to selectively form the phosphor layer 4 at uniform thickness and in a required region. In other words, in such an LED chip of the very small size, for example, if a jet dispenser method is used, since the size of liquid droplets is large (a minimum size of about 200 µm), it may be substantially impossible to selectively form a phosphor layer at equal thickness and in a required region. In a spray coat method, it is possible to apply a liquid material to a selective region by using a mask. However, this method is originally a method of applying the liquid material to a large area. Therefore, this method is not suitable as a method of applying the liquid material to each chip. It may be difficult to apply the liquid material to chip side surfaces.

On the other hand, in the electrostatic application, as explained above, since the liquid material can be applied as the liquid droplets of 50 µm to 100µm, even if the LED chip is the LED chip of the very small size, it is possible to selectively apply the liquid material to a required region and at uniform or substantially uniform thickness.

In the light-emitting device 10 according to this embodiment, the phosphor layer 4 is formed only on the upper surface and the corners 3d of the LED chip 3. This is because, in this embodiment, the LED chip 3 is mounted on the substrate 1 with its face up and, in this case, the semiconductor light-emitting layer 3b of the LED chip 3 is present on the upper surface side and the light from the LED chip 3 is emitted only from the upper surface of the LED chip 3 and the corners 3d continuous from the upper surface. In this embodiment, since the electrostatic application is used for the formation of the phosphor layer 4, it is possible to easily perform such selective application. Compared with the light-emitting device in which the phosphor layer is provided over the entire surface of the LED chip 3, it is possible to reduce an amount of use of phosphors. Further, it is possible to obtain the light-emitting device 10 having a satisfactory light emission characteristic.

### Second Embodiment

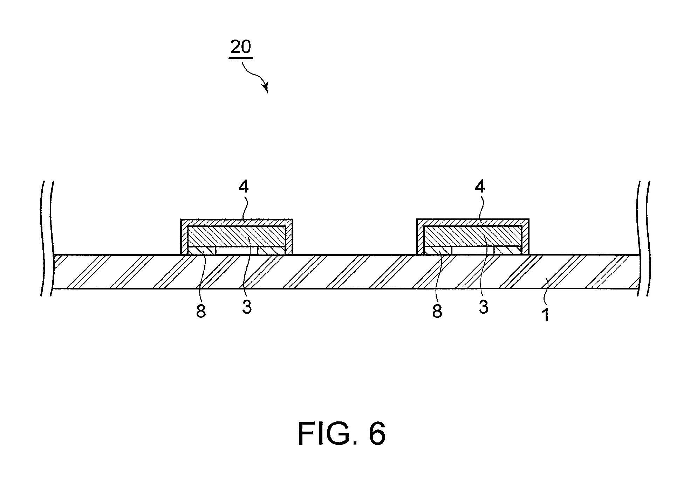

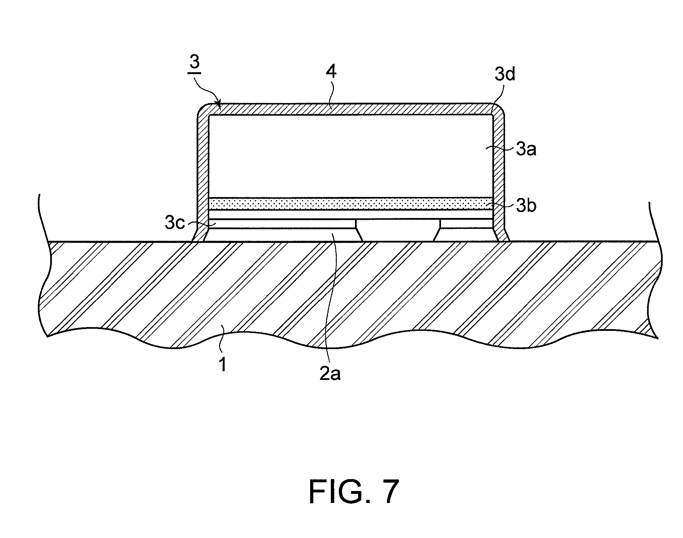

FIG. 6 is a sectional view of an example of a light-emitting device manufactured according to a second embodiment. FIG. 7 is an enlarged sectional view of a main part of the light-emitting device. In this embodiment, to avoid redundant explanation, explanation of similarities to the first embodiment is omitted or simplified and differences from the first embodiment are mainly explained.

A light-emitting device 20 shown in FIGS. 6 and 7 includes the substrate 1, a wiring layer (not shown in the figures) formed on the substrate 1, the LED chips 3 functioning as light-emitting elements, and the phosphor layers 4.

In the light-emitting device 20, the LED chip 3 is mounted on the substrate 1 with its face down, i.e., mounted by flip-chip mounting for directly connecting the element electrode 3c of the LED chip 3 to an electrode 2a of the wiring layer on the substrate 1. In this case, the semiconductor light-emitting layer 3b formed on the LED chip 3 is located on the substrate 1 side. Light emitted from the semiconductor light-emitting layer 3b is emitted from not only the upper surface of the LED chip 3 (a surface on the opposite side of a surface on which the element electrodes 3c are formed) but also the side surfaces of the LED chip 3. Therefore, in the light-emitting device 20, the phosphor layer 4 is provided to cover the entire surface of the LED chip 3, i.e., provided on all of the upper surface, the side surfaces, and the corners 3d of the LED chip 3. In this embodiment, as in the first embodiment, the phosphor layer 4 is formed by electrostatically applying dispersed liquid by, for example, the electrostatic coating device 30 shown in FIG. 3 and hardening the dispersed liquid. The phosphor layer 4 is formed at substantially uniform thickness.

Although not shown in the figures, in this embodiment, as in the first embodiment, the phosphor layer 4 may be formed to contain different phosphors or the like depending on regions using two or more kinds of dispersed liquid having different compositions.

For the purpose of improving heat conductivity of the phosphor layer 4, an inorganic filler having satisfactory heat conductivity and optical transparency, for example, powder of silica, tantalum oxide (TaO), or zinc oxide (ZnO) can be contained in the dispersed liquid together with the phosphor particles. An inorganic filler having a particle diameter smaller than the particle diameter of the phosphors in use is desirably used.

In the second embodiment, as in the first embodiment, since the phosphor layer 4 is formed by the electrostatic application, the phosphor layer 4 can be formed in substantially uniform thickness. Therefore, the heat conduction from the phosphor to the LED chip 3 can be improved and the heat radiation properties can be improved. Therefore, it is possible to sufficiently cope with the increase in power of a light-emitting device in recent years and realize light emission at a large light amount and high efficiency. Since phosphors do not excessively adhere, it is possible to reduce a phosphor amount.

Further, since the thickness is uniform, it is possible to suppress occurrence of color unevenness. Further, it is possible to prevent occurrence of the blue ring phenomenon that occurs when if the phosphor layer 4 is not sufficiently provided on the corners 3d of the LED chip 3.

Even if the LED chip 3 is, for example, an LED chip of a very small size of 0.2mmx0.2mm having an area of 0.04 mm², it is possible to form the phosphor layer 4 at uniform thickness.

In both the embodiments explained above, the phosphor layer is formed by electrostatically applying the dispersed liquid in which the phosphor particles are dispersed in the liquid transparent resin. However, electrostatic spraying can also be used instead of the electrostatic application. In the electrostatic spraying, liquid droplets are refined by charging and sprayed. As in the electrostatic application, it is possible to form a uniform or substantially uniform film (phosphor layer).

However, in the electrostatic spraying, since the liquid droplets are sprayed to spread from above to under an object (an LED chip), it may be difficult to form a uniform film to side surfaces of the LED chip. Therefore, as in the second embodiment, if it is necessary to form a phosphor layer to the side surfaces of the LED chip, it is desirable to use the electrostatic application. As in the first embodiment, if the phosphor layer is formed on the upper surface of the LED chip and the corners continuous from the upper surface, either the electrostatic application or the electrostatic spraying may be used.

While certain embodiments have been described, these embodiments have been presented by way of example only, and are not intended to limit the scope of the inventions. Indeed, the novel embodiments described herein may be embodied in a variety of other forms; furthermore, various omissions, substitutions, and changes in the form of the embodiments described herein may be made without departing from the spirit of the inventions. The accompanying claims and their equivalents are intended to cover such forms or modifications as would fall within the scope and spirit of the inventions. Examples

Specific examples of the present invention and evaluation results of the examples are explained below.

### Example 1

Plural blue LED chips (575µm×325µm×170µm, electrode pads of φ70 µm) that emitted blue light having wavelength of 450 nm to 460 nm were bonded on a ceramics substrate, which was provided with an Ag wiring layer, by a silicone adhesive. The blue LED chip and the Ag wiring layer on the ceramic substrate were electrically joined by wire bonding.

Phosphors in micron order having an average particle diameter (D50) of 11 µm, which were excited by the blue light to emit light, were mixed and dispersed in silicone resin.

Dispersed liquid of the phosphors was electrostatically applied to the upper surface of the LED chip on the ceramics substrate and corners continuous from the upper surface (excluding the electrode pads) to be hardened using the electrostatic coating device (spraying nozzle distal end diameter: 1. 6 mm) 30 shown in FIG. 3. Then, the light-emitting device 10 including a phosphor layer having substantially uniform thickness on the upper surface of the LED chip and the corners continuous from the upper surface (excluding the electrode pads) was manufactured.

When the obtained light-emitting device 10 was caused to emit light, light without color unevenness was obtained. The blue ring phenomenon was not observed.

As a comparative example 1, manufacturing of a light-emitting device having the same configuration as the example 1 was attempted in the same manner as the example 1 except that a jet dispenser (liquid droplet diameter: about 200 µm) was used instead of the electrostatic coating device 30. However, a phosphor layer having uniform thickness was unable to be formed on the upper surface of the LED chip and the corners continuous from the upper surface (excluding the electrode pads).

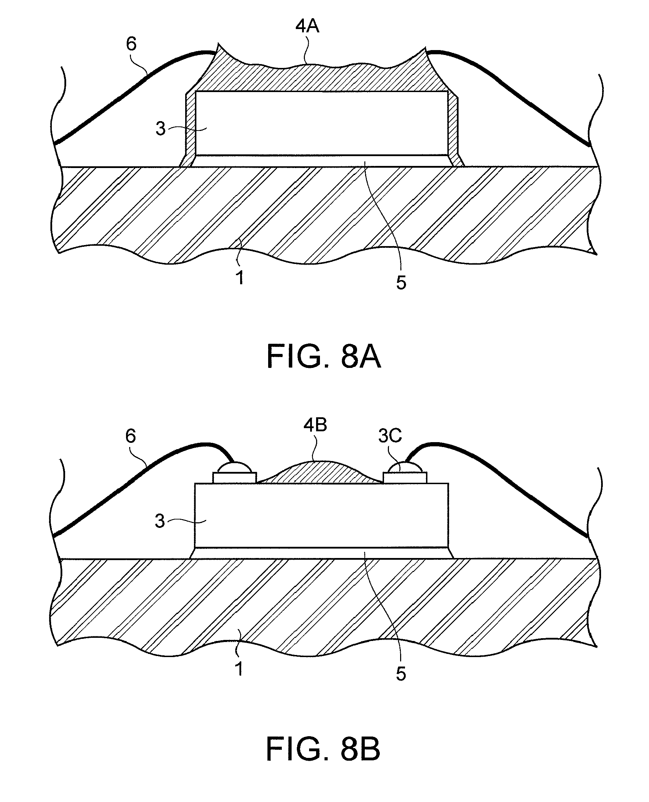

Specifically, when the liquid droplets were applied twice between the electrode pads on the upper surface of the LED chip 3, as shown in FIG. 8A, the dispersed liquid adhered to the bonding wire 6 portions as well and a phosphor layer 4A having a concave shape in cross section was formed. When the liquid droplets were applied once between the electrode pads on the upper surface of the LED chip 3, as shown in FIG. 8B, a phosphor layer 4B having a convex shape in cross section was formed. In both the cases, the phosphor layers were hardly formed on the corners 3d of the LED chip 3.

When light-emitting devices obtained in the comparative example 1 (light-emitting devices shown in FIGS. 8A and 8B) were caused to emit light, color unevenness was seen and the blue ring phenomenon was observed in both the light-emitting devices.

### Example 2

When a light-emitting device was manufactured in the same manner as the example 1 except that a blue LED chip (200µm×200µm×170µm, electrode pads of φ70 µm) was used as the LED chip 3, a phosphor layer having uniform thickness was able to be formed on the upper surface of the LED chip on the ceramics substrate and the corners continuous from the upper surface (excluding the electrode pads). When the obtained light-emitting device was caused to emit light, light without color unevenness was obtained and the blue ring phenomenon was not observed.

### Example 3

A blue LED chip (800µm×800µm×170µm, electrode pads of φ150 µm) was used as the LED chip 3, the LED chip was AuSn-flip-chip joined on the ceramics substrate 1, phosphor containing dispersed liquid prepared in the same manner as in the example 1 was applied to the upper surface, the side surfaces, and the corners of the LED chip of the ceramics substrate to be hardened using the electrostatic coating device (spraying nozzle distal end diameter: 1.6 mm) 30 shown in FIG. 3. Then, a light-emitting device having a phosphor layer having substantially uniform thickness on the upper surface, the side surfaces, and the corners of the LED chip was manufactured. When the obtained light-emitting device was caused to emit light, light without color unevenness was obtained and the blue ring phenomenon was not observed.

## Claims

1. A manufacturing method for a light-emitting device comprising:
mounting a light-emitting element on a substrate (1); and
dispersing, in liquid transparent resin, phosphor particles in micron order excited by light radiated from the light-emitting element (3) to emit light and electrostatically applying or electrostatically spraying dispersed liquid of the phosphor particles to thereby form a layer including the phosphor particles on an upper surface of the light-emitting element (3).

2. The manufacturing method according to claim 1,
wherein in the mounting the light-emitting element (3), the light-emitting element (3) is mounted on the substrate (1) with its face down, and
in the forming the layer including the phosphor particles, the layer including the phosphor particles is substantially uniformly formed from an upper surface to side surfaces of the light-emitting element (3).

3. The manufacturing method according to claim 1,
wherein
in the mounting the light-emitting element (3), the light-emitting element (3) is mounted on the substrate (1) with its face up, and
in the forming the layer including the phosphor particles, the layer including the phosphor particles is formed on an upper surface of the light-emitting element (1) and corners (3d) continuous from the upper surface excluding element electrodes (3c) provided on the upper surface.

4. The manufacturing method according any of claims 1 to 3, wherein, in the forming the layer including the phosphor particles, a heat conductive filler in submicron order is further dispersed in the dispersed liquid together with the phosphor particles.

5. The manufacturing method according any of claims 1 to 4, wherein the forming the layer including the phosphor particles includes:
electrostatically applying or electrostatically spraying first dispersed liquid in which first phosphor particles are dispersed; and
electrostatically applying or electrostatically spraying second dispersed liquid in which second phosphor particles are dispersed.

6. The manufacturing method according to claim 1,
wherein
the substrate (1) has thickness of 0.5 mm to 1.5 mm, and heat conductivity of the substrate at 25°C is equal to or higher than 30 W/m.K.

7. The manufacturing method according to claim 1,
wherein the phosphor particles have an average particle diameter of 3 µm to 20 µm.

8. The manufacturing method according to claim 1,
wherein the phosphor particles have an average particle diameter of 3 µm to 10 µm.

9. The manufacturing method according to claim 1,
wherein different phosphors are contained in the dispersing liquid depending on regions using two or more kinds of dispersed liquid having different compositions.

10. The manufacturing method according to claim 4,
wherein the heat conductive filler includes an inorganic filler of silica, tantalum oxide (TaO), or zinc oxide (ZnO) and has a particle diameter smaller than a particle diameter of the phosphor.

11. The manufacturing method according to claim 1,
wherein, in the electrostatic application or the electrostatic spraying, the dispersed liquid is applied or sprayed as liquid droplets of 50 µm to 100 µm.
